# EUROPEAN PATENT APPLICATION

(11) **EP 4 819 419 A1**
(43) Date of publication of application: **07.10.2026**
(21) Application number: 24911075.0
(22) Date of filing: 23.12.2024
(51) Int. Cl.: H01S 5/042

(54) **LASER DRIVING CIRCUIT AND RELATED APPARATUS**

(30) Priority: 28.12.2023 CN 202311842594
(71) Applicant: Yinwang Intelligent Technologies Co., Ltd., Shenzhen, Guangdong 518110 (CN)
(72) Inventor: WANG, Yi, Shenzhen, Guangdong 518129 (CN); QIN, Jiarong, Shenzhen, Guangdong 518129 (CN); CAI, Zhonghua, Shenzhen, Guangdong 518129 (CN); PANG, Zhiyuan, Shenzhen, Guangdong 518129 (CN); YU, Anliang, Shenzhen, Guangdong 518129 (CN)
(74) Representative: Pfenning, Meinig & Partner mbB
(86) International application number: PCT/CN2024/141639
(87) International publication number: WO 2025/140148

(57) **Abstract**

A laser drive circuit and a related apparatus are provided, and are applied to the field of lidar technologies. The laser drive circuit includes: at least one laser unit (10), at least one energy storage unit (20), a drive unit (30), a first voltage control unit (40), and a second voltage control unit (50). A first end (101) of the at least one laser unit (10) is connected to a first end (401) of the first voltage control unit (40), a second end (102) of the at least one laser unit (10) is connected to a first end (301) of the drive unit (30), a first end (201) of the at least one energy storage unit (20) is connected to the first end (401) of the first voltage control unit (40), a second end (202) of the at least one energy storage unit (20) is connected to a first end (501) of the second voltage control unit (50), a second end (402) of the first voltage control unit (40) is grounded, a second end (302) of the drive unit (30) is grounded, and a second end (502) of the second voltage control unit (50) is grounded. The laser drive circuit can increase a transmit power of a laser and improve driving efficiency of the laser.

## Description

This application claims priority to Chinese Patent Application No. 202311842594.6, filed with the China National Intellectual Property Administration on December 28, 2023 and entitled "LASER DRIVE CIRCUIT AND RELATED APPARATUS", which is incorporated herein by reference in its entirety.

### TECHNICAL FIELD

This application relates to the field of lidar technologies, and in particular, to a laser drive circuit and a related apparatus.

### BACKGROUND

With development of information technologies and computer vision, detection technologies develop rapidly, and various detection apparatuses bring great convenience to people's life and travel. The detection apparatus may be considered as an "eye" for a device to sense an environment, and includes a vision system sensor like a camera, and a radar system sensor like a millimeter-wave radar, a lidar, and an ultrasonic radar.

A lidar (light detection and ranging, Lidar, or referred to as a light detection and ranging apparatus) has advantages of high resolution, good detection performance, and strong concealment, and plays an important role in a process of sensing the environment by the device. In particular, the lidar has been widely applied in the field of intelligent driving, to facilitate further development of intelligent driving technologies. A coherent lidar is a radar that uses frequency-modulated signal light as a transmit signal to detect a target, and processes local oscillation (local oscillation, LO) of the transmit signal and a return signal of the transmit signal to obtain related information of the target.

Driving of a laser is very important to the detection performance of the lidar. Therefore, to enable better detection performance of the lidar, how to improve driving efficiency of the laser is a hot topic being studied by persons skilled in the art.

### SUMMARY

Embodiments of this application provide a laser drive circuit and a related apparatus, to improve driving efficiency of a laser.

**According to a first aspect,** an embodiment of this application provides a laser drive circuit. The laser drive circuit includes:
at least one laser unit, at least one energy storage unit, a drive unit, a first voltage control unit, and a second voltage control unit.

A first end of the at least one laser unit is connected to a first end of the first voltage control unit, a second end of the at least one laser unit is connected to a first end of the drive unit, a first end of the at least one energy storage unit is connected to the first end of the first voltage control unit, a second end of the at least one energy storage unit is connected to a first end of the second voltage control unit, a second end of the first voltage control unit is grounded, a second end of the drive unit is grounded, and a second end of the second voltage control unit is grounded.

In this embodiment of this application, the laser drive circuit is provided. The at least one laser unit and the at least one energy storage unit in the laser drive circuit are connected in parallel. The at least one laser unit may be one laser, or may be two or more lasers. The at least one energy storage unit may be one capacitor, or may be two or more capacitors. This is not limited in embodiments of this application. The first voltage control unit in the laser drive circuit is connected to the at least one laser unit, and provides a stable operating voltage for the at least one laser unit, so that the at least one laser unit can transmit an optical signal. The first voltage control unit is connected to the at least one energy storage unit, and provides a voltage for the at least one energy storage unit, so that the at least one energy storage unit can store electric energy. The second voltage control unit in the laser drive circuit is connected to the at least one energy storage unit, so that a voltage difference between two ends of the at least one energy storage unit can be reduced, and electric energy that can be stored by the at least one energy storage unit accordingly changes.

Energy storage effect of an energy storage unit in a current laser drive circuit is poor, resulting in a low transmit power of a laser. In addition, a feeding trace in the laser drive circuit is excessively long, resulting in a large electric energy loss. Consequently, driving efficiency of the laser is low.

However, in the laser drive circuit in this embodiment of this application, the voltage difference between the two ends of the energy storage unit can be reduced by the second voltage control unit, so that an energy storage unit with a smaller withstand voltage can be selected. The energy storage unit with a smaller withstand voltage corresponds to a larger optional maximum capacitance, so that electric energy that can be stored by the energy storage unit can be accordingly increased, energy storage effect of the energy storage unit can be improved, and the transmit power of the laser can be increased. In addition, because the voltage difference between the two ends of the energy storage unit is reduced, the energy storage unit with a smaller withstand voltage can be selected, and the energy storage unit with a smaller withstand voltage corresponds to a smaller volume, an energy storage unit with a smaller volume can be selected, to reduce a length of the feeding trace in the laser drive circuit, reduce an electric energy loss, and improve driving efficiency of the laser.

**In a possible implementation,** the first voltage control unit is configured to provide a first voltage for the at least one energy storage unit, the second voltage control unit is configured to control a voltage difference between the first end and the second end of the at least one energy storage unit to be less than a first threshold, the at least one energy storage unit is configured to supply power to the at least one laser unit, and the drive unit is configured to drive the at least one laser unit to transmit an optical signal.

In this implementation of this application, a possible specific implementation of functions of components in the laser drive circuit is provided. Specifically, the first voltage control unit provides the first voltage for the at least one energy storage unit, so that the at least one energy storage unit can store electric energy. Correspondingly, the first voltage control unit also provides the first voltage for the at least one laser unit, so that the at least one laser unit can transmit the optical signal under the stable first voltage. The second voltage control unit is configured to control the voltage difference between the first end and the second end of the at least one energy storage unit to be less than the first threshold, so that a bias voltage applied to the two ends of the energy storage unit is smaller (relative to the first voltage). Therefore, the energy storage unit with a smaller withstand voltage can be selected, and correspondingly, more electric energy can be stored. This can improve the energy storage effect of the energy storage unit, and increase the transmit power of the laser. In addition, because the bias voltage at the two ends of the energy storage unit is smaller, the energy storage unit with a smaller withstand voltage can be selected, and correspondingly, a corresponding volume of the energy storage unit is smaller. Therefore, the energy storage unit with a smaller volume can be selected, to reduce the length of the feeding trace in the laser drive circuit, reduce the electric energy loss, and improve the driving efficiency of the laser. The energy storage unit with a smaller volume is selected, so that a smaller package can be used, to improve integration of the laser drive circuit.

**In a possible implementation,** the second voltage control unit includes:
a second capacitor and a second power supply.

A first end of the second capacitor is connected to the second end of the at least one energy storage unit, a second end of the second capacitor is grounded, a first end of the second power supply is connected to the second end of the at least one energy storage unit, and a second end of the second power supply is grounded.

The second power supply is configured to provide a second voltage for the second capacitor, where the second voltage is less than or equal to the first voltage provided by the first voltage control unit.

In this implementation of this application, a possible specific implementation of the second voltage control unit is provided. Specifically, the second voltage control unit includes the second capacitor and the second power supply, and the second capacitor and the second power supply are connected in parallel. The second power supply provides the second voltage for the second capacitor, and the second voltage is less than or equal to the first voltage, so that the bias voltage applied to the two ends of the energy storage unit is smaller (relative to the first voltage). Therefore, the energy storage unit with a smaller withstand voltage can be selected, and correspondingly, more electric energy can be stored. This can improve the energy storage effect of the energy storage unit, and increase the transmit power of the laser. In addition, because the bias voltage at the two ends of the energy storage unit is smaller, the energy storage unit with a smaller withstand voltage can be selected, and correspondingly, a corresponding volume of the energy storage unit is smaller. Therefore, the energy storage unit with a smaller volume can be selected, to reduce the length of the feeding trace in the laser drive circuit, reduce the electric energy loss, and improve the driving efficiency of the laser. The energy storage unit with a smaller volume is selected, so that a smaller package can be used, to improve integration of the laser drive circuit.

**In a possible implementation,** the laser drive circuit further includes:
at least one switch unit.

A first end of the at least one switch unit is connected to the first end of the first voltage control unit, and a second end of the at least one switch unit is connected to the first end of the at least one laser unit and the first end of the at least one energy storage unit.

The at least one switch unit is turned on or turned off to control the first voltage control unit to provide the first voltage for the at least one energy storage unit.

In this implementation of this application, a possible specific implementation of the laser drive circuit is provided. Specifically, the laser drive circuit further includes the at least one switch unit to be turned on or turned off to control the first voltage control unit to provide the first voltage for the energy storage unit. It may be understood that the at least one switch unit may be a plurality of switches that are separately disposed between a plurality of energy storage units and the first voltage control unit. When the switch unit is turned on, a path is formed between the first voltage control unit and the energy storage unit, the first voltage control unit provides the first voltage for the energy storage unit, and the energy storage unit is in a charging state. When the switch unit is turned off, the first voltage control unit is disconnected from the energy storage unit, the first voltage control unit no longer provides the voltage for the energy storage unit, and the energy storage unit is in a discharging state.

**In a possible implementation,** the drive unit includes:
a driver.

A first end of the driver is connected to the second end of the at least one laser unit, a third end of the driver is connected to a signal amplification unit, and a second end of the driver is grounded.

The driver is configured to drive the at least one laser unit to transmit the optical signal.

In this implementation of this application, a possible specific implementation of the drive unit is provided. Specifically, the drive unit includes the driver, configured to drive the laser unit to transmit the optical signal. Optionally, the driver may be specifically a metal oxide semiconductor (metal oxide semiconductor, MOS) driver, a gallium nitride driver, or the like. This is not limited in embodiments of this application.

**In a possible implementation,** the first voltage control unit includes:
a first power supply.

A first end of the first power supply is connected to the first end of the at least one laser unit and the first end of the at least one energy storage unit, and a second end of the first power supply is grounded.

The first power supply is configured to provide the first voltage for the at least one energy storage unit.

In this implementation of this application, a possible specific implementation of the first voltage control unit is provided. Specifically, the first voltage control unit includes the first power supply, and the first power supply provides the first voltage for the at least one energy storage unit, so that the at least one energy storage unit can store electric energy. Correspondingly, the first power supply also provides the first voltage for the at least one laser unit, so that the at least one laser unit can transmit the optical signal under the stable first voltage.

**In a possible implementation,** in a first time period, the first voltage control unit is configured to supply power to the at least one energy storage unit, and the at least one energy storage unit is in a charging state; and in a second time period, the at least one energy storage unit is configured to supply power to the at least one laser unit, and the at least one energy storage unit is in a discharging state.

In this implementation of this application, a possible specific implementation of an operating state of the laser drive circuit is provided. Specifically, the first voltage control unit first supplies power to the energy storage unit. In this case, the energy storage unit is in the charging state. After a period of continuous power supply, the first voltage control unit stops supplying power to the energy storage unit, and the energy storage unit starts to supply power to the laser unit. In this case, the energy storage unit is in the discharging state. According to embodiments of this application, the energy storage effect of the energy storage unit can be improved, the transmit power of the laser can be increased, and the length of the feeding trace in the laser drive circuit can be reduced, to reduce the electric energy loss, and improve the driving efficiency of the laser.

**According to a second aspect,** an embodiment of this application provides a chip. The chip includes the laser drive circuit according to the first aspect or any possible implementation of the first aspect.

**According to a third aspect,** an embodiment of this application provides a radar or a radar system. The radar or the radar system includes the laser drive circuit according to the first aspect or any possible implementation of the first aspect, or includes the chip according to the second aspect.

In a possible implementation, the radar includes but is not limited to a lidar and the like.

In a possible implementation, there may be a smart sensor integrated with a plurality of sensors. When the smart sensor includes but is not limited to a laser detection function and the like, the smart sensor may also be referred to as a radar or a radar system.

**According to a fourth aspect,** an embodiment of this application provides a terminal device. The terminal device includes the laser drive circuit according to the first aspect or any possible implementation of the first aspect, or includes the chip according to the second aspect, or includes the radar or the radar system according to the third aspect.

**According to a fifth aspect,** an embodiment of this application provides a vehicle. The vehicle includes the laser drive circuit according to the first aspect or any possible implementation of the first aspect, or includes the chip according to the second aspect, or includes the radar or the radar system according to the third aspect, or includes the terminal device according to the fourth aspect.

In embodiments of this application, a voltage difference between two ends of an energy storage unit can be reduced by a second voltage control unit, so that an energy storage unit with a smaller withstand voltage can be selected. The energy storage unit with a smaller withstand voltage corresponds to a larger optional maximum capacitance, so that electric energy that can be stored by the energy storage unit can be accordingly increased, energy storage effect of the energy storage unit can be improved, and a transmit power of a laser can be increased. In addition, because the voltage difference between the two ends of the energy storage unit is reduced, the energy storage unit with a smaller withstand voltage can be selected, and the energy storage unit with a smaller withstand voltage corresponds to a smaller volume, an energy storage unit with a smaller volume can be selected, to reduce a length of a feeding trace in a laser drive circuit, reduce an electric energy loss, and improve driving efficiency of the laser.

### BRIEF DESCRIPTION OF DRAWINGS

To describe the technical solutions in embodiments of this application more clearly, the following briefly describes the accompanying drawings for describing embodiments of this application. It is clear that the accompanying drawings in the following descriptions show merely some embodiments of this application, and persons of ordinary skill in the art may derive other drawings from these accompanying drawings without creative efforts.
FIG. 1 is a diagram of a relationship between a capacitance of a capacitor and a bias voltage according to an embodiment of this application;
FIG. 2 is a diagram of a structure of a laser drive circuit according to an embodiment of this application;
FIG. 3 is a diagram of a structure of a laser drive circuit according to an embodiment of this application;
FIG. 4 is a diagram of a structure of a laser drive circuit according to an embodiment of this application;
FIG. 5 is a diagram of a structure of a laser drive circuit according to an embodiment of this application;
FIG. 6 is a diagram of a control signal according to an embodiment of this application; and
FIG. 7 is a diagram of a structure of a laser drive circuit according to an embodiment of this application.

### DESCRIPTION OF EMBODIMENTS

To make objectives, technical solutions, and advantages of this application clearer, the following describes embodiments of this application with reference to accompanying drawings in embodiments of this application.

In the specification, claims, and accompanying drawings of this application, terms "first", "second", and the like are intended to distinguish between different objects but do not indicate a particular order. In addition, terms such as "include" and "have" and any other variants thereof are intended to cover a non-exclusive inclusion. For example, processes, methods, systems, products, or devices that include a series of steps or units are not limited to listed steps or units, but instead, optionally further include steps or units that are not listed, or optionally further include other steps or units inherent to these processes, methods, products, or devices.

"Embodiments" mentioned herein mean that specific features, structures, or characteristics described in combination with embodiments may be included in at least one embodiment of this application. The phrase shown in various locations in the specification may not necessarily refer to a same embodiment, and is not an independent or optional embodiment exclusive from another embodiment. A person skilled in the art may explicitly and implicitly understand that, in embodiments of this application, unless otherwise stated or there is a logical conflict, terms and/or descriptions in embodiments are consistent and may be mutually referenced, and technical features in different embodiments may be combined according to an internal logical relationship thereof, to form a new embodiment.

It should be understood that, in this application, "at least one (item)" means one or more, "a plurality of" means two or more, "at least two (items)" means two, three, or more, and "and/or" is used to describe an association relationship between associated objects, and indicates that there may be three relationships. For example, "A and/or B" may indicate that only A exists, only B exists, and both A and B exist, where A and B may be singular or plural. The character "/" generally represents an "or" relationship between the associated objects. "At least one of the following items (pieces)" or a similar expression thereof means any combination of these items, including any combination of singular items (pieces) or plural items (pieces). For example, at least one of a, b, or c may indicate a, b, c, a and b, a and c, b and c, or a, b, and c, where a, b, and c may be singular or plural.

As described in the background, to make a lidar have better detection performance, how to improve driving efficiency of a laser is a hot topic being studied by persons skilled in the art. However, energy storage effect of an energy storage unit in a current laser drive circuit is poor, resulting in a low transmit power of the laser. In addition, a feeding trace in the laser drive circuit is excessively long, resulting in a large electric energy loss. Consequently, driving efficiency of the laser is low.

In view of this, this application provides a laser drive circuit and a related apparatus, and relates to the field of lidar technologies, to increase a transmit power of a laser and improve driving efficiency of the laser.

To describe the solutions of this application more clearly, the following describes the laser drive circuit and the related apparatus that are provided in this application with reference to the accompanying drawings.

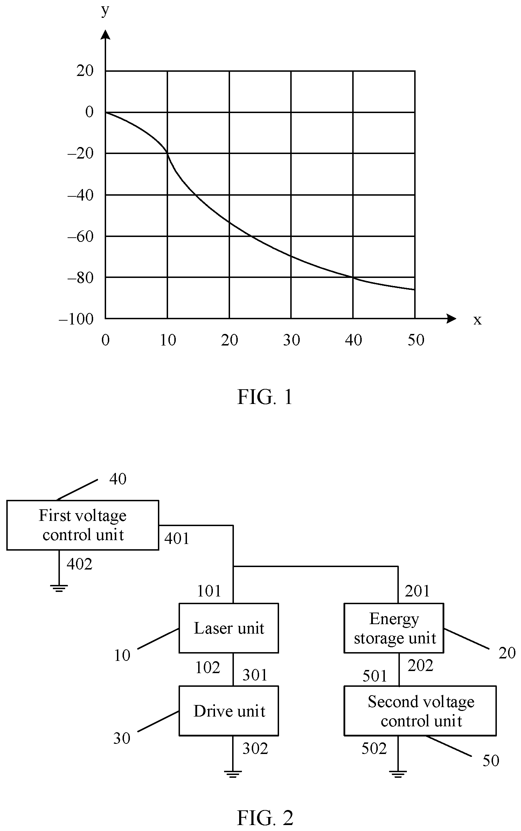

FIG. 1 is a diagram of a relationship between a capacitance of a capacitor and a bias voltage according to an embodiment of this application.

As shown in FIG. 1, a horizontal axis x indicates the bias voltage, and a vertical axis y indicates an actual capacitance of the capacitor, namely, a charge storage amount under a given potential difference.

It can be learned from FIG. 1 that, in a case of a direct current bias, the actual capacitance of the capacitor is decreased as the bias voltage is increased.

In addition, a capacitor with a larger withstand voltage corresponds to a smaller optional maximum capacitance, and a capacitor with a smaller withstand voltage corresponds to a larger optional maximum capacitance. A capacitor with a larger withstand voltage corresponds to a larger capacitor volume, and a capacitor with a smaller withstand voltage corresponds to a smaller capacitor volume.

For example, for a type of packaging capacitor with a withstand voltage of 50 V, a corresponding optional maximum capacitance is 1.5 nF, and a volume of the capacitor is large. For a type of packaging capacitor with a withstand voltage of 25 V, a corresponding optional maximum capacitance is 220 nF, and a volume of the capacitor is small.

Therefore, when the bias voltage is smaller, a capacitor with a smaller withstand voltage may be selected, so that a corresponding optional maximum capacitance is larger, and a corresponding capacitor volume is smaller. When the bias voltage is larger, a capacitor with a larger withstand voltage may be selected, so that a corresponding optional maximum capacitance is smaller, and a corresponding capacitor volume is larger.

FIG. 2 is a diagram of a structure of a laser drive circuit according to an embodiment of this application.

As shown in FIG. 2, **the laser drive circuit includes:**
**at least one laser unit 10, at least one energy storage unit 20, a drive unit 30, a first voltage control unit 40, and a second voltage control unit 50.**

A first end 101 of the at least one laser unit 10 is connected to a first end 401 of the first voltage control unit 40, a second end 102 of the at least one laser unit 10 is connected to a first end 301 of the drive unit 30, a first end 201 of the at least one energy storage unit 20 is connected to the first end 401 of the first voltage control unit 40, a second end 202 of the at least one energy storage unit 20 is connected to a first end 501 of the second voltage control unit 50, a second end 402 of the first voltage control unit 40 is grounded, a second end 302 of the drive unit 30 is grounded, and a second end 502 of the second voltage control unit 50 is grounded.

It can be learned that the at least one laser unit and the at least one energy storage unit are connected in parallel. The at least one laser unit may be one laser, or may be two or more lasers. The at least one energy storage unit may be one capacitor, or may be two or more capacitors. This is not limited in embodiments of this application.

The first voltage control unit in the laser drive circuit is connected to the at least one laser unit, and provides a stable operating voltage for the at least one laser unit, so that the at least one laser unit can transmit an optical signal. The first voltage control unit is connected to the at least one energy storage unit, and provides a voltage for the at least one energy storage unit, so that the at least one energy storage unit can store electric energy.

The second voltage control unit in the laser drive circuit is connected to the at least one energy storage unit, so that a voltage difference between two ends of the at least one energy storage unit can be reduced. Therefore, an energy storage unit with a smaller withstand voltage can be selected. The energy storage unit with a smaller withstand voltage corresponds to a larger optional maximum capacitance, so that electric energy that can be stored by the at least one energy storage unit can be accordingly increased. The energy storage unit with a smaller withstand voltage corresponds to a smaller volume, so that a volume of the at least one energy storage unit is accordingly decreased.

Energy storage effect of an energy storage unit in a current laser drive circuit is poor, resulting in a low transmit power of a laser. In addition, a feeding trace in the laser drive circuit is excessively long, resulting in a large electric energy loss. Consequently, driving efficiency of the laser is low.

However, in the laser drive circuit in this embodiment of this application, the voltage difference between the two ends of the energy storage unit can be reduced by the second voltage control unit, so that the energy storage unit with a smaller withstand voltage can be selected. The energy storage unit with a smaller withstand voltage corresponds to a larger optional maximum capacitance, so that electric energy that can be stored by the energy storage unit can be accordingly increased, energy storage effect of the energy storage unit can be improved, and the transmit power of the laser can be increased. In addition, because the voltage difference between the two ends of the energy storage unit is reduced, the energy storage unit with a smaller withstand voltage can be selected, and the energy storage unit with a smaller withstand voltage corresponds to a smaller volume, an energy storage unit with a smaller volume can be selected, to reduce a length of the feeding trace in the laser drive circuit, reduce an electric energy loss, and improve driving efficiency of the laser.

Optionally, the laser unit may be a laser, and the energy storage unit may be a capacitor. Details are not described again below.

**Further, functions performed by components in the laser drive circuit may be specifically as follows:**

The first voltage control unit 40 is configured to provide a first voltage for the at least one energy storage unit 20, the second voltage control unit 50 is configured to control a voltage difference between the first end 201 and the second end 202 of the at least one energy storage unit 20 to be less than a first threshold, the at least one energy storage unit 20 is configured to supply power to the at least one laser unit 10, and the drive unit 30 is configured to drive the at least one laser unit 10 to transmit the optical signal.

It may be understood that the second voltage control unit is configured to control the voltage difference between the first end and the second end of the at least one energy storage unit to be less than the first threshold, so that a bias voltage applied to the two ends of the energy storage unit is smaller (relative to the first voltage). Therefore, the energy storage unit with a smaller withstand voltage can be selected.

It can be learned from the foregoing descriptions in FIG. 1 that a capacitor with a smaller withstand voltage corresponds to a larger optional maximum capacitance, and corresponds to a smaller capacitor volume.

Therefore, the energy storage unit with a smaller withstand voltage can be selected by using an execution function of the second voltage control unit, and the corresponding optional maximum capacitance is larger, so that the energy storage effect of the energy storage unit can be improved, and the transmit power of the laser can be increased. In addition, the corresponding volume of the corresponding energy storage unit is smaller, so that an energy storage unit with a smaller volume can be selected, and the energy storage unit and the laser unit are more closely arranged spatially. In this way, a length of a feeding trace between the energy storage unit and the laser unit can be reduced, the electric energy loss can be reduced, and the driving efficiency of the laser can be improved. Because the energy storage unit and the laser unit are more closely arranged spatially, the volume of the energy storage unit is reduced, and a smaller package can be used, to improve integration of the laser drive circuit.

**In a possible embodiment, the second voltage control unit 50 may specifically include:**
**a second capacitor C2 and a second power supply V2.**

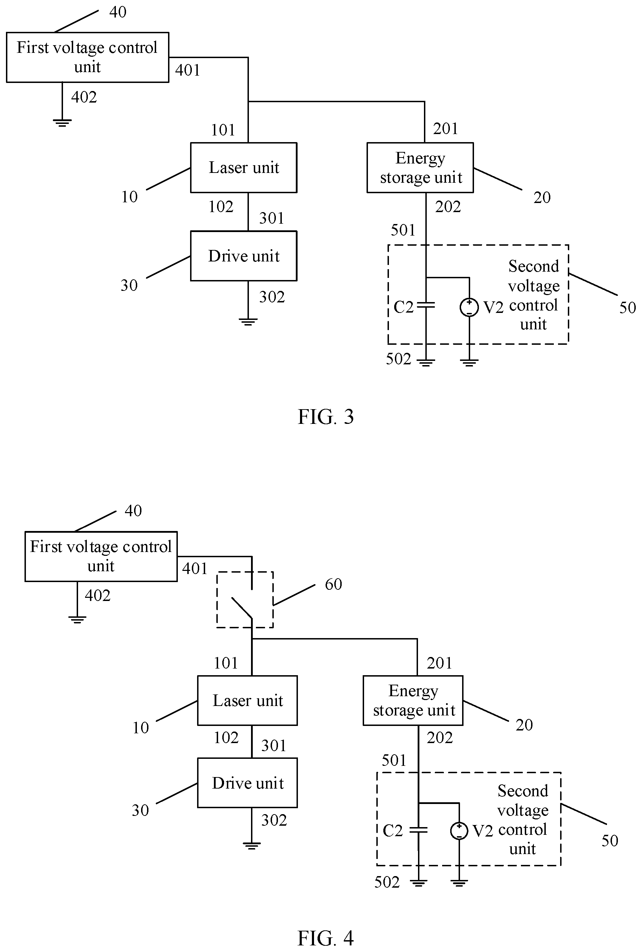

For details, refer to FIG. 3. FIG. 3 is a diagram of a structure of the laser drive circuit according to an embodiment of this application.

As shown in FIG. 3, a first end of the second capacitor C2 is connected to the second end of the at least one energy storage unit 20, a second end of the second capacitor C2 is grounded, a first end of the second power supply V2 is connected to the second end of the at least one energy storage unit 20, and a second end of the second power supply V2 is grounded.

The second power supply V2 is configured to provide a second voltage for the second capacitor, where the second voltage is less than or equal to the first voltage provided by the first voltage control unit.

For example, the first voltage provided by the first voltage control unit for the energy storage unit is 50 V, and the second voltage provided by the second power supply for the second capacitor is 25 V. In this case, the bias voltage applied to the two ends of the energy storage unit is 25 V, which is smaller than the first voltage 50 V. Therefore, an energy storage unit with a smaller withstand voltage can be selected, and a corresponding optional maximum capacitance is larger, so that the energy storage effect of the energy storage unit can be improved, and the transmit power of the laser can be increased. In addition, the corresponding volume of the corresponding energy storage unit is smaller, so that an energy storage unit with a smaller volume can be selected, and the energy storage unit and the laser unit are more closely arranged spatially. In this way, a length of a feeding trace between the energy storage unit and the laser unit can be reduced, the electric energy loss can be reduced, and the driving efficiency of the laser can be improved. Because the energy storage unit and the laser unit are more closely arranged spatially, the volume of the energy storage unit is reduced, and a smaller package can be used, to improve integration of the laser drive circuit.

**In a possible embodiment, the laser drive circuit may further include:**
**at least one switch unit 60.**

For details, refer to FIG. 4. FIG. 4 is a diagram of a structure of the laser drive circuit according to an embodiment of this application.

As shown in FIG. 4, a first end of the at least one switch unit 60 is connected to the first end of the first voltage control unit 40, and a second end of the at least one switch unit 60 is connected to the first end of the at least one laser unit 10 and the first end of the at least one energy storage unit 20.

The at least one switch unit 60 is turned on or turned off to control the first voltage control unit 40 to provide the first voltage for the at least one energy storage unit 20.

It may be understood that the at least one switch unit may be a plurality of switches that are separately disposed between a plurality of energy storage units and the first voltage control unit. When the switch unit is turned on, a path is formed between the first voltage control unit and the energy storage unit, the first voltage control unit provides the first voltage for the energy storage unit, and the energy storage unit is in a charging state. After the energy storage unit is charged for a period of time, charges at the two ends of the energy storage unit are balanced. In this case, the switch unit is turned off, the first voltage control unit is disconnected from the energy storage unit, the first voltage control unit no longer provides a voltage for the energy storage unit, and the energy storage unit provides electric energy for the laser unit, so that the laser unit can transmit the optical signal, and the energy storage unit is in a discharging state.

Optionally, after the energy storage unit is charged for a period of time, charges at the two ends of the energy storage unit are balanced, and the switch unit may not be turned off. In this case, even if the switch unit remains in a turned-on state, the first voltage control unit no longer provides a voltage for the energy storage unit, and the energy storage unit provides electric energy for the laser unit, so that the laser unit can transmit the optical signal, and the energy storage unit is in a discharging state.

**In a possible embodiment, the drive unit may specifically include:**
**a driver.**

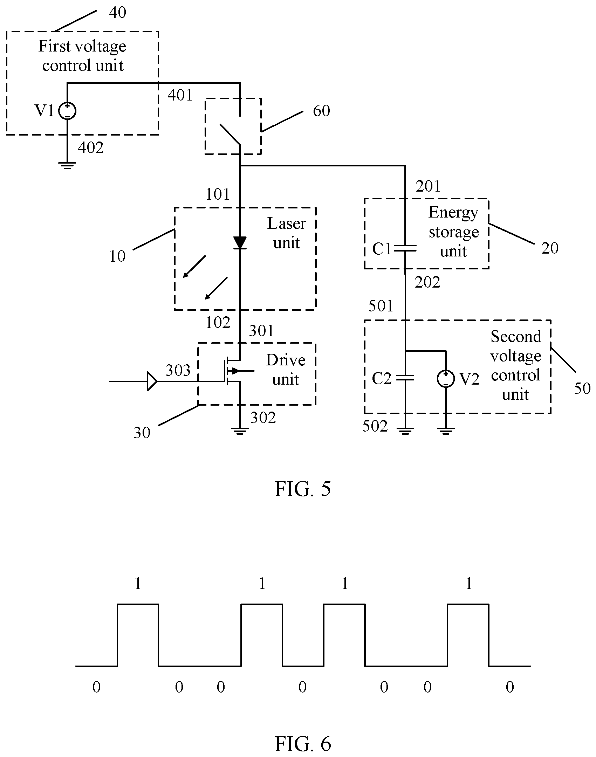

For details, refer to FIG. 5. FIG. 5 is a diagram of a structure of the laser drive circuit according to an embodiment of this application.

As shown in FIG. 5, a first end 301 of the driver is connected to the second end 102 of the at least one laser unit 10, a third end 303 of the driver is connected to a signal amplification unit, and a second end 302 of the driver is grounded.

The driver is configured to drive the at least one laser unit 10 to transmit the optical signal.

Optionally, the driver may be specifically a metal oxide semiconductor (metal oxide semiconductor, MOS) driver, a gallium nitride driver, or the like. This is not limited in embodiments of this application.

Optionally, the laser unit 10 may be a laser, and the energy storage unit 20 may be a capacitor C1.

Optionally, the first voltage control unit 40 may specifically include:
a first power supply V1.

A first end 401 of the first power supply V1 is connected to the first end of the at least one laser unit 10 and the first end 201 of the at least one energy storage unit 20 through the switch unit 60, and a second end 402 of the first power supply V1 is grounded.

The first power supply V1 is configured to provide the first voltage for the at least one energy storage unit 20.

Optionally, in any one of the foregoing possible laser drive circuits in FIG. 2 to FIG. 5, an operating procedure of the laser drive circuit may be as follows:

In a first time period, the first voltage control unit is configured to supply power to the at least one energy storage unit, and the at least one energy storage unit is in the charging state; and in a second time period, the at least one energy storage unit is configured to supply power to the at least one laser unit, and the at least one energy storage unit is in the discharging state.

It may be understood that, the first voltage control unit first supplies power to the energy storage unit. In this case, the energy storage unit is in the charging state. After a period of continuous power supply, the first voltage control unit stops supplying power to the energy storage unit, and the energy storage unit starts to supply power to the laser unit. In this case, the energy storage unit is in the discharging state.

According to embodiments of this application, the energy storage effect of the energy storage unit can be improved, the transmit power of the laser can be increased, and the length of the feeding trace in the laser drive circuit can be reduced, to reduce the electric energy loss, and improve the driving efficiency of the laser.

Optionally, whether the laser unit transmits the optical signal is related to a control signal of the drive unit.

The control signal is transmitted to the drive unit through the amplification unit, and whether the laser unit transmits the optical signal is controlled by controlling the drive unit to be turned on or off.

Optionally, the control signal may be specifically a square wave signal including "0" and "1".

For details, refer to FIG. 6. FIG. 6 is a diagram of a control signal according to an embodiment of this application.

As shown in FIG. 6, the control signal is a square wave signal that alternately appears at a high level and a low level. The control signal may include a transmission control command, or may include a data segment or a data block. In the control signal, "0" corresponds to the low level, and "1" corresponds to the high level. For example, the control signal is a control command. The control signal is at the low level "0" in a first time period, the high level "1" in a second time period, the low level "0" in a third time period, the low level "0" in a fourth time period, and the high level "1" in a fifth time period. A sum of duration of the five time periods may be used as a cycle, and levels corresponding to the five time periods repeatedly appear in a next cycle, and may be used to periodically transmit the same control command. It may be understood that the high level and the low level in the control signal are not voltages corresponding to two specific values, but correspond to two voltage ranges. The control signal described in this embodiment of this application may be a control signal that is in the laser drive circuit and that is used to drive the laser unit to transmit the optical signal.

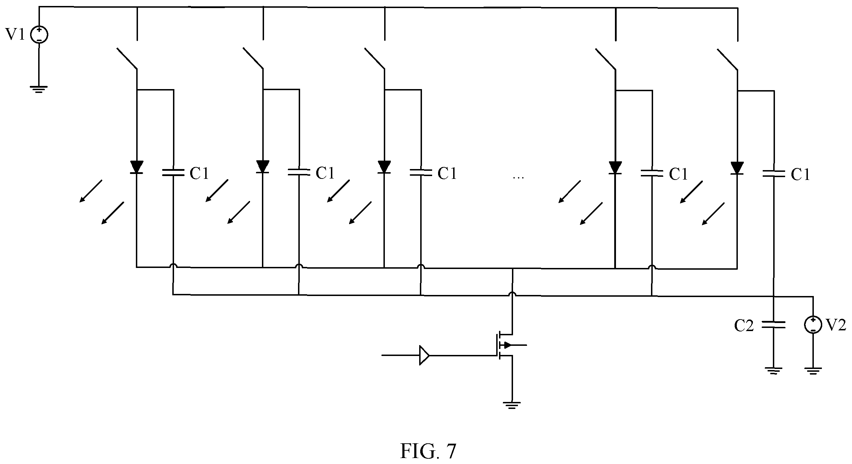

FIG. 7 is a diagram of a structure of a laser drive circuit according to an embodiment of this application.

As shown in FIG. 7, compared with any one of the foregoing possible laser drive circuits in FIG. 2 to FIG. 5, the laser drive circuit in this embodiment of this application includes a plurality of laser units and a plurality of energy storage units.

It may be understood that a parallel circuit including the plurality of laser units and the plurality of energy storage units may share one second voltage control unit (including C2 and V2). One second voltage control unit is used, so that a bias voltage applied to two ends of each of the plurality of energy storage units is smaller. Therefore, an energy storage unit with a smaller withstand voltage can be selected, and correspondingly, more electric energy can be stored. This can improve energy storage effect of the plurality of energy storage units at the same time, and increase a transmit power of a laser. In addition, because the bias voltage at the two ends of the energy storage unit is smaller, the energy storage unit with a smaller withstand voltage can be selected, and correspondingly, a corresponding volume of the energy storage unit is smaller. Therefore, an energy storage unit with a smaller volume can be selected, to reduce a length of a feeding trace in a laser drive circuit, reduce an electric energy loss, and improve driving efficiency of the laser. The energy storage unit with a smaller volume is selected, so that a smaller package can be used, to improve integration of the laser drive circuit.

This application provides a chip. The chip includes the laser drive circuit provided in this application.

This application provides a radar or a radar system. The radar or the radar system includes the laser drive circuit or the chip provided in this application.

In a possible implementation, the radar includes but is not limited to a lidar and the like.

In a possible implementation, there may be a smart sensor integrated with a plurality of sensors. When the smart sensor includes but is not limited to a laser detection function and the like, the smart sensor may also be referred to as a radar or a radar system.

This application further provides a terminal device. The terminal device includes the laser drive circuit, the chip, the radar, or the radar system provided in this application. For example, the terminal device may be a transportation tool, for example, a transportation means used in any possible scenario, for example, a vehicle, a truck, an aircraft, an unmanned aerial vehicle, a slow transport vehicle, a spacecraft, or a ship, or may be any device that can carry a detection apparatus, for example, a surveying and mapping device. One or more laser drive circuits, chips, radars, or radar systems provided in this application are deployed on the terminal device.

The foregoing descriptions are merely specific implementations of this application, but are not intended to limit the protection scope of this application. Any variation or replacement readily figured out by persons skilled in the art within the technical scope disclosed in this application shall fall within the protection scope of this application. Therefore, the protection scope of this application shall be subject to the protection scope of the claims.

## Claims

1. A laser drive circuit, wherein the laser drive circuit comprises:
at least one laser unit, at least one energy storage unit, a drive unit, a first voltage control unit, and a second voltage control unit, wherein
a first end of the at least one laser unit is connected to a first end of the first voltage control unit, a second end of the at least one laser unit is connected to a first end of the drive unit, a first end of the at least one energy storage unit is connected to the first end of the first voltage control unit, a second end of the at least one energy storage unit is connected to a first end of the second voltage control unit, a second end of the first voltage control unit is grounded, a second end of the drive unit is grounded, and a second end of the second voltage control unit is grounded.

2. The circuit according to claim 1, wherein the first voltage control unit is configured to provide a first voltage for the at least one energy storage unit, the second voltage control unit is configured to control a voltage difference between the first end and the second end of the at least one energy storage unit to be less than a first threshold, the at least one energy storage unit is configured to supply power to the at least one laser unit, and the drive unit is configured to drive the at least one laser unit to transmit an optical signal.

3. The circuit according to claim 1 or 2, wherein the second voltage control unit comprises:
a second capacitor and a second power supply, wherein
a first end of the second capacitor is connected to the second end of the at least one energy storage unit, a second end of the second capacitor is grounded, a first end of the second power supply is connected to the second end of the at least one energy storage unit, and a second end of the second power supply is grounded; and
the second power supply is configured to provide a second voltage for the second capacitor, wherein the second voltage is less than or equal to the first voltage provided by the first voltage control unit.

4. The circuit according to any one of claims 1 to 3, wherein the laser drive circuit further comprises:
at least one switch unit, wherein
a first end of the at least one switch unit is connected to the first end of the first voltage control unit, and a second end of the at least one switch unit is connected to the first end of the at least one laser unit and the first end of the at least one energy storage unit; and
the at least one switch unit is turned on or turned off to control the first voltage control unit to provide the first voltage for the at least one energy storage unit.

5. The circuit according to any one of claims 1 to 4, wherein the drive unit comprises:
a driver, wherein
a first end of the driver is connected to the second end of the at least one laser unit, a third end of the driver is connected to a signal amplification unit, and a second end of the driver is grounded; and
the driver is configured to drive the at least one laser unit to transmit the optical signal.

6. The circuit according to any one of claims 1 to 5, wherein the first voltage control unit comprises:
a first power supply, wherein
a first end of the first power supply is connected to the first end of the at least one laser unit and the first end of the at least one energy storage unit, and a second end of the first power supply is grounded; and
the first power supply is configured to provide the first voltage for the at least one energy storage unit.

7. The circuit according to any one of claims 1 to 6, wherein in a first time period, the first voltage control unit is configured to supply power to the at least one energy storage unit, and the at least one energy storage unit is in a charging state; and in a second time period, the at least one energy storage unit is configured to supply power to the at least one laser unit, and the at least one energy storage unit is in a discharging state.

8. A chip, wherein the chip comprises the laser drive circuit according to any one of claims 1 to 7.

9. A radar, wherein the radar comprises the laser drive circuit according to any one of claims 1 to 7 or the chip according to claim 8.

10. A terminal device, wherein the terminal device comprises the laser drive circuit according to any one of claims 1 to 7, or the chip according to claim 8, or the radar according to claim 9.

11. A vehicle, wherein the vehicle comprises the laser drive circuit according to any one of claims 1 to 7, or the chip according to claim 8, or the radar according to claim 9, or the terminal device according to claim 10.
